# EUROPÄISCHE PATENTANMELDUNG

(11) **EP 1 710 825 A2**
(43) Veröffentlichungstag der Anmeldung: **11.10.2006**
(21) Anmeldenummer: 06006772.5
(22) Anmeldetag: 30.03.2006
(51) Int. Cl.: H01H 85/046

(54) **Sicherungsvorrichtung zum Sichern eines Elektrogeräts vor Überstrom**

(30) Priorität: 04.04.2005 DE 102005015424
(71) Anmelder: Patent-Treuhand-Gesellschaft für elektrische Glühlampen mbH, 81543 München (DE)
(72) Erfinder: Busse, Olaf, 80686 München (DE); Heckmann, Markus, 81539 München (DE); Lecheler, Reinhard, 86633 Neuburg/Donau (DE); Lechner, Alfons, 86558 Hohenwart (DE); Mayer, Siegfried, 85452 Moosinning (DE); Pollischansky, Thomas, 86391 Stadtbergen (DE); Rudolph, Bernd, 85659 Forstern (DE); Schemmel, Bernhard, 82234 Wessling (DE); Schmidtmann, Kay, Dr., 81827 München (DE); Schmitt, Harald, 80689 München (DE); Siegmund, Thomas, Dr., 83624 Otterfing (DE); Storm, Arwed, 85221 Dachau (DE); Werni, Horst, 80937 München (DE)

(57) **Zusammenfassung**

Sicherungsvorrichtung zum Sichern eines Elektrogeräts vor Überstrom mit zumindest einem elektrisch leitenden Element (4, 4a, 4b), welches bei Erreichen des Überstroms schmilzt und mit einer ersten und zumindest einer zweiten Betriebsspannungs-Potentialfläche (1, 2), wobei jede der Betriebsspannungs-Potentialflächen (1, 2) mit jeweils einer Betriebsspannungs-Zuleitung elektrisch verbunden ist, und zumindest die erste Betriebsspannungs-Potentialfläche (1,2) zumindest zwei Teile (11, 12; 21, 22) aufweist, wobei die beiden Teile (11, 12; 21, 22) durch das elektrisch leitende Element (4, 4a, 4b) elektrisch verbunden sind. Des Weiteren umfasst die Sicherungsvorrichtung eine Kunststoff-Trennwand (3), welche zwischen der ersten (1) und der zweiten Betriebsspannungs-Potentialfläche (2) angeordnet ist, wobei die Kunststoff-Trennwand (3) an einer Unterseite eines Bauteilereservoirs (5) des Elektrogeräts angeordnet ist und mit dem Bauteilreservoir (5) mechanisch fest verbunden ist.

## Beschreibung

### Technisches Gebiet

Die vorliegende Erfindung betrifft eine Sicherungsvorrichtung zum Sichern eines Elektrogeräts vor Überstrom gemäß dem Oberbegriff des Anspruchs 1. Die Erfindung betrifft insbesondere eine kostengünstige Überstromsicherung, die durch konstruktive Merkmale platzsparend in einem Gehäuse des Elektrogeräts ausgebildet werden kann.

### Stand der Technik

Überstromsicherungen für Elektrogeräte werden beispielsweise in elektronischen Vorschaltgeräten für elektrische Lampen ausgebildet. Diesbezüglich ist es erforderlich, wenn eine Betriebsspannung aus einer Netzspannungsversorgung für das elektrische Vorschaltgerät entnommen wird, das ein normkonformes Absichern von Betriebsspannungs-Zuleitungen zu dem elektronischen Vorschaltgerät gegen Überstrom abgesichert werden. Daher ist es erforderlich, dass das Elektrogerät eine Sicherungsvorrichtung aufweist, die den Betriebsstrom überwacht, den das Elektrogerät bzw. das elektronische Vorschaltgerät der Netzspannungsversorgung entnimmt. Die Sicherungsvorrichtung ist dabei derart ausgebildet, dass sie dann, wenn der Betriebsstrom als Überstrom auftritt und somit über einen Stromschwellwert tritt, die Stromzufuhr von der Netzspannungsversorgung zum Elektrogerät trennt.

Um eine relativ kostengünstige Ausbildung einer derartigen Sicherungsvorrichtung ausführen zu können ist es bekannt, dass sogenannte Leiterbahnsicherungen eingesetzt werden. Diesbezüglich werden entsprechende Leiterbahnen auf einer Leiterplatte ausgebildet. Im Allgemeinen werden dem Elektrogerät zwei Betriebsspannungs-Zuleitungen zugeführt, wobei jede der beiden Betriebsspannungs-Zuleitungen mit je einer dieser Leiterbahnen verbunden ist. Dadurch bilden sich zwei Betriebsspannungs-Potentialflächen in Form dieser Leiterbahnen aus. Eine der beiden Betriebsspannungs-Potentialflächen ist dabei aus zwei Teilen gebildet, welche durch ein elektrisch leitendes Element elektrisch verbunden sind, wobei der entsprechende Betriebsstrom auch über das elektrisch leitende Element fließt. Das elektrisch leitende Element ist dabei im Vergleich zu den beiden Teilen der Leiterbahn als ein relativ dünnes Stück Leiterbahn ausgeführt, wodurch erreicht werden kann, dass im Falle eines Überstroms dieses dünne Leiterbahnstück schmilzt und eine entsprechende Sicherheitsvorrichtung gewährleistet ist.

Ein Problem derartiger Leiterbahnsicherungen mit einem dünnen Leiterbahnstück als elektrisch leitendes Element zur Überstromsicherung ist darin zu sehen, dass beim Ansprechen dieser Sicherung und somit beim Schmelzen des dünnen Leiterbahnstücks, Metalldampf gebildet wird, welcher sich über die beiden Betriebsspannungs-Potentialflächen ausbreitet. Als Folge davon kann es zur Ausbildung eines Lichtbogens zwischen den beiden Betriebsspannungs-Potentialflächen kommen, wodurch es zu Beschädigungen oder Gefahrensituationen kommen kann. Diesbezüglich kann es auch zu einem Brand des Elektrogerätes kommen.

Zur Vermeidung eines derartigen Lichtbogens bzw. derartiger Gefahrensituationen ist aus der deutschen Offenlegungsschrift DE 101 53 814 A1 eine Sicherungsvorrichtung bekannt, bei der eine Leiterplatte mit zwei Betriebsspannungs-Potentialflächen in einem Kunststoffgehäuse eines Elektrogeräts angeordnet ist. Die Leiterplatte ist dabei auf Stegen der Gehäusewand aufliegend angeordnet. Darüber hinaus ist mittels Kunststoff-Trennwänden ein derartiger Bereich gebildet, dass die Betriebsspannungs-Potentialfläche, welche einen als Sicherungselement ausgebildeten Leiterbahnbereich aufweist, von der zweiten Betriebsspannungs-Potentialfläche abgetrennt ist. Die Kunststoff-Trennwände bilden dabei einen dreieckigen Bereich, wobei sich die Kunststoff-Trennwände von der Gehäuse-Bodenplatte in Richtung der Leiterplatte erstrecken. Diejenige Kunststoff-Trennwand, welche den Bodenschenkel der dreieckigen Anordnung der Kunststoff-Trennwände bildet, ist in einer Schrägstellung zwischen der ersten Betriebsspannungs-Potentialfläche und der zweiten Betriebsspannungs-Potentialfläche ausgebildet. Diesbezüglich erstreckt sich diese Kunststoff-Trennwand teilweise über einen ersten Teil der zweiten Betriebsspannungs-Potentialfläche. Des Weiteren ist ein Öffnungsbereich zwischen dieser den Bodenschenkel bildenden Kunststoff-Trennwand und einer einen Seitenschenkel bildenden weiteren Kunststoff-Trennwand ausgebildet. Durch diesen Öffnungsbereich, welcher auf der der ersten Betriebsspannungs-Potentialfläche abgewandten Seite der zweiten Betriebsspannungs-Potentialfläche ausgebildet ist, kann der im Sicherungsfall beim Schmelzen des dünnen Leiterbahnbereichs auftretende Metalldampf abgeleitet werden. Diese bekannte Konstruktion ist jedoch relativ aufwändig und benötigt relativ viel Platz.

Des Weiteren ist es bekannt, Elektrogeräte wie beispielsweise elektronische Vorschaltgeräte in Metallgehäusen anzuordnen. Zur Abtrennung von zwei Betriebsspannungs-Potentialflächen werden entsprechende Kunststoffwannen stirnseitig an dem Metallgehäuse angebracht, um ein korrektes Auslösen einer Leiterbahnsicherung zu unterstützen. Des Weiteren ist es bekannt, dass Leiterbahnsicherungen vergossen werden bzw. beschichtet werden. Darüber hinaus ist es auch möglich, dass bei ausreichenden Platzverhältnissen und nicht zu niederohmigen Eingangsfiltern dafür gesorgt werden kann, dass sich in einem angemessenen Abstand der Leiterbahnsicherung keine weiteren Leiterbahnen befinden.

Bei vielen Elektrogeräten, insbesondere elektronischen Vorschaltgeräten, ist es jedoch nicht möglich, eine Kunststoffwanne stimseitig anzubringen. Oftmals ist dies jedoch auch aus Kostcngründen nicht sinnvoll. Des Weiteren ist es bei derartigen elektronischen Vorschaltgeräten aus thermischen Gründen oftmals nicht erforderlich, die Leiterbahnsicherungen zu vergießen, dennoch muss ein derartiges Vergießen durchgeführt werden, um die korrekte Funktion der Leiterbahnsicherung sicherstellen zu können.

Des Weiteren sind die aus dem Stand der Technik bekannten Kunststoff-Trennwände lediglich an- bzw. aufliegend angeordnet, wodurch eine positionsstabile Halterung nicht ausreichend gewährleistet werden kann.

### Darstellung der Erfindung

Der vorliegenden Erfindung liegt daher die Aufgabe zugrunde, eine gattungsgemäße Sicherungsvorrichtung bereitzustellen, die einerseits kostengünstig und platzsparend realisiert werden kann und andererseits eine zuverlässige Unterbrechung des Betriebsstroms im Überstromfall bewerkstelligt.

Diese Aufgabe wird durch eine Sicherungsvorrichtung, welche die Merkmale nach Patentanspruch 1 aufweist, gelöst.

Eine erfindungsgemäße Sicherungsvorrichtung zum Sichern eines Elektrogeräts vor Überstrom weist ein elektrisch leitendes Element auf, welches bei Erreichen des Überstroms schmilzt. Des Weiteren umfasst die Sicherungsvorrichtung eine erste und zumindest eine zweite Betriebsspannungs-Potentialfläche, wobei jede der beiden Betriebsspannungs-Potentialflächen mit jeweils einer Betriebsspannungszuleitung elektrisch verbunden ist. Zumindest eine der beiden Betriebsspannungs-Potentialflächen, beispielsweise die erste Betriebsspannungs-Potentialfläche, weist zumindest zwei Teile auf, wobei die beiden Teile durch das elektrisch leitende Element elektrisch verbunden sind. Darüber hinaus umfasst die Sicherungsvorrichtung zumindest eine Kunststoff-Trennwand, welche zwischen der ersten und der zweiten Betriebsspannungs-Potentialfläche angeordnet ist. Ein wesentlicher Gedanke der Erfindung besteht darin, dass die Kunststoff-Trennwand an einer Unterseite eines Bauteilereservoirs des Elektrogeräts angeordnet ist und mit dem Bauteilereservoir mechanisch fest verbunden ist. Die erfindungsgemäße Sicherungsvorrichtung ermöglicht dadurch eine positionsstabile Platzierung der Kunststoff Trennwand zu dem Bauteilereservoir, insbesondere zu den beiden Betriebsspannungs-Potentialflächen. Des Weiteren kann erreicht werden, dass die Sicherungsvorrichtung kostengünstig und vor allen Dingen platzsparend realisiert werden kann. Darüber hinaus ist es bei der erfindungsgemäßen Sicherungsvorrichtung nicht mehr erforderlich, das elektrisch leitende Element zu vergießen, bzw. zu beschichten. Die erfindungsgemäße Sicherungsvorrichtung ermöglicht darüber hinaus, dass die Kunststoff-Trennwand relativ nahe zum elektrisch leitenden Element angeordnet werden kann, wodurch diesbezüglich auch vorgesehen sein kann, dass in dem Elektrogerät mehrere derartige elektrisch leitende Elemente relativ nahe zueinander angeordnet werden können.

In vorteilhafter Weise ist die Kunststoff-Trennwand durch eine Steckverbindung mit dem Bauteilereservoir mechanisch fest verbunden. Es kann vorgesehen sein, dass die mechanisch feste Verbindung zwischen der Kunststoff-Trennwand und dem Bauteilereservoir lösbar ausgebildet ist. Unter einer festen mechanischen Verbindung wird dabei eine derartige Verbindung verstanden, mit der die Kunststoff-Trennwand positionsstabil zu dem Bauteilereservoir bzw. zu den Betriebsspannungs-Potentialflächen angeordnet werden kann, wobei diese Positionsstabilität allein durch die mechanische Verbindung zwischen der Kunststoff-Trennwand und dem Bauteilereservoir gewährleistet werden kann.

Es kann vorgesehen sein, dass die Steckverbindung Einsteckstifte aufweist, welche an der Kunststoff-Trennwand ausgebildet sind und in vorteilhafter Weise eine Länge aufweisen, die der Dicke des Bauteilereservoirs entspricht. Diesbezüglich kann die mechanische Verbindung sicher ausgebildet werden, welche darüber hinaus schnell und einfach gelöst werden kann. Des Weiteren kann diesbezüglich, wenn die Höhe der Einsteckstifte der Dicke des Bauteilereservoirs entspricht, ermöglicht werden, dass im Einsteckbereich der Einsteckstifte in das Bauteilereservoir an der Oberseite des Bauteilereservoirs beliebige Bauteile angeordnet werden können.

Es kann vorgesehen sein, dass sich die Kunststoff-Trennwand teilweise über zumindest eine der beiden Betriebsspannungs-Potentialflächen und/oder über dem elektrisch leitenden Element erstreckt. Es kann vorgesehen sein, dass sich zumindest ein erster Teil der Kunststoff-Trennwand in vorteilhafter Weise über dem elektrisch leitenden Element erstreckt, insbesondere mittig über dem elektrisch leitenden Element angeordnet ist. Diesbezüglich kann erreicht werden, dass die elektrisch leitenden Elemente relativ kurz ausgebildet werden können und somit eine kompaktere und platzsparendere Bauweise der Sicherungsvorrichtung gewährleistet werden kann.

Als geometrische Formgestaltungen für die Kunststoff-Trennwand kann eine L-Form oder H-Form oder T-Form vorgesehen sein. Diesbezüglich kann vorgesehen sein, dass die Kunststoff-Trennwand derart orientiert ist, dass ein erster Teil im Wesentlichen vertikal zu den Vorzugsrichtungen der Betriebsspannungs-Potentialflächen insbesondere zur Vorzugsrichtung des elektrisch leitenden Elements angeordnet ist und zumindest ein zweiter Teil im Wesentlichen parallel zur Vorzugsrichtung der Betriebsspannungs-Potentialflächen angeordnet ist und insbesondere zwischen den Betriebsspannungs-Potentialflächen ausgebildet ist. Auch dadurch kann eine besonders platzsparende Ausbildung der Sicherungsvorrichtung ermöglicht werden.

Es kann vorgesehen sein, dass zumindest zwei Betriebsspannungs-Potentialflächen jeweils zweiteilig ausgebildet sind und jeweils mit einem separaten elektrisch leitenden Element eine elektrische Verbindung zwischen den jeweiligen Teilen der Betriebsspannungs-Potentialflächen ausgebildet ist. Diesbezüglich kann vorgesehen sein, dass jede der Betriebsspannungs-Potentialflächen zweiteilig ausgebildet ist und jeweils ein elektrisch leitendes Element zwischen den beiden Teilen der Betriebsspannungs-Potentialflächen ausgebildet ist. Dadurch kann eine besonders effektive und sichere Ausgestaltung der Sicherungsvorrichtung erzielt werden.

In vorteilhafter Weise ist das Bauteilereservoir als Leiterplatte ausgebildet, wobei das elektrisch leitende Element durch eine Leiterbahn ausgebildet ist. Es kann des Weiteren vorgesehen sein, dass das Elektrogerät insbesondere ein elektronisches Vorschaltgerät für elektrische Lampen ist und in einem Metallgehäuse angeordnet ist. Dadurch kann in bevorzugter Weise auch bei derartigen Elektrogeräten, welche ein Metallgehäuse aufweisen, eine möglichst sichere und platzsparende Realisierung der Sicherungsvorrichtung ermöglicht werden. Darüber hinaus ist es nicht mehr erforderlich, die Leiterbahnsicherungen zu vergießen oder zu beschichten.

Weitere vorteilhafte Ausführungsformen ergeben sich aus den Unteransprüchen.

### Kurze Beschreibung der Zeichnungen

Im Nachfolgenden werden mehrere Ausführungsbeispiele der Erfindung anhand schematischer Zeichnungen näher erläutert. Es zeigen:
- Figur 1: ein erstes Ausführungsbeispiel einer erfindungsgemäßen Sicherungsvorrichtung;
- Figur 2: ein zweites Ausführungsbeispiel einer erfindungsgemäßen Sicherungsvorrichtung;
- Figur 3: ein drittes Ausführungsbeispiel einer erfindungsgemäßen Sicherungsvorrichtung;
- Figur 4: ein viertes Ausführungsbeispiel einer erfindungsgemäßen Sicherungsvorrichtung; und
- Figur 5: eine Schnittdarstellung des Ausführungsbeispiels der erfindungsgemäßen Sicherungsvorrichtung gemäß Figur 4.

### Bevorzugte Ausführung der Erfindung

In den Figuren werden gleiche oder funktionsgleiche Elemente mit gleichen Bezugszeichen versehen.

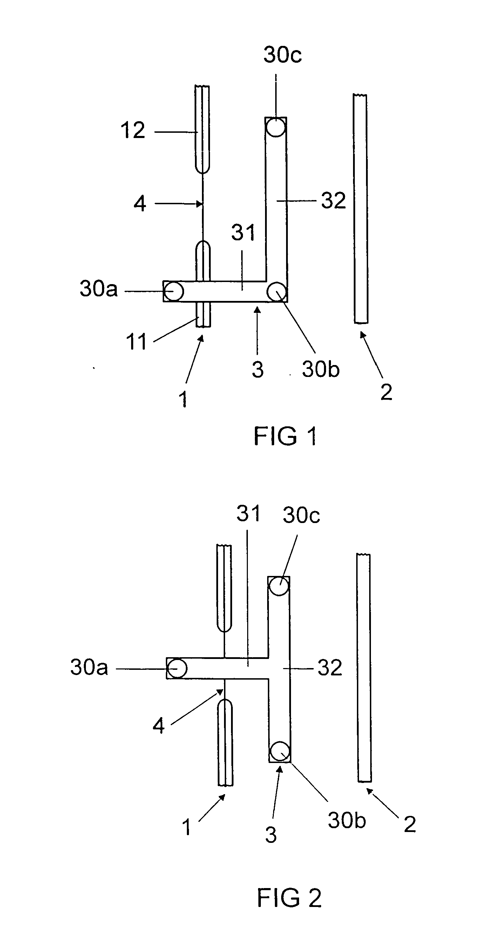

In Figur 1 ist ein erstes Ausführungsbeispiel der erfindungsgemäßen Sicherungsvorrichtung mit den wesentlichen Merkmalen gezeigt. Die Sicherungsvorrichtung ist zum Sichern eines elektronischen Vorschaltgeräts für elektrische Lampen ausgebildet und in einem Metallgehäuse (nicht dargestellt) des elektronischen Vorschaltgeräts angeordnet. In Figur 1 ist eine Darstellung gezeigt, bei der auf eine Unterseite einer Leiterplatte (nicht dargestellt) gesehen wird. Die Sicherungsvorrichtung umfasst eine erste Leiterbahn 1 und eine zweite Leiterbahn 2, die an dieser Unterseite der Leiterplatte angeordnet sind. Diese beiden Leiterbahnen 1 und 2 sind jeweils mit einer nicht dargestellten Betriebsspannungs-Zuleitung verbunden, wodurch die erste Leiterbahn 1 eine erste Betriebsspannungs-Potentialfläche und die Leiterbahn 2 eine zweite Betriebsspannungs-Potentialfläche bilden. Wie aus der Darstellung gemäß Figur 1 zu erkennen ist, ist die erste Leiterbahn 1 zweigeteilt ausgebildet und weist einen ersten Teil 11 und einen zweiten Teil 12 auf. Die beiden Teile 11 und 12 sind beabstandet zueinander angeordnet und durch ein elektrisch leitendes Element 4, welches im Ausführungsbeispiel als Leiterbahn ausgebildet ist, elektrisch verbunden. Wie in Figur 1 gezeigt, ist das als Leiterbahnsicherung ausgebildete elektrisch leitende Element 4 dünn im Vergleich zu den Ausdehnungen der Teile 11 und 12 ausgebildet. Diese schmale Ausbildung der Leiterbahnsicherung bzw. des elektrisch leitenden Elements 4 ist derart gestaltet, dass das elektrisch leitende Element 4 im Überstromfall schmilzt.

Darüber hinaus umfasst die erfindungsgemäße Sicherungsvorrichtung eine Kunststoff-Trennwand 3, welche mittels einer Steckverbindung mit der Leiterplatte, insbesondere der Unterseite der Leiterplatte, mechanisch fest verbunden ist. Diesbezüglich sind an der Kunststoff-Trennwand 3 Einsteckstifte 30a, 30b und 30c ausgebildet, welche in entsprechende Einsteckbereiche in der Leiterplatte eingesteckt werden. Somit ist die Kunststoff-Trennwand 3 positionsstabil zu der Leiterplatte und den Leiterbahnen 1 und 2 angeordnet. Wie aus der Darstellung gemäß Figur 1 zu erkennen ist, sind die Einsteckstifte 30a und 30c an den freien Enden der L-förmigen Kunststoff-Trennwand 3 ausgebildet. Der dritte Einsteckstift 30b ist im Eckbereich der L-förmigen Ausgestaltung der Kunststoff-Trennwand 3 angeordnet.

Die Kunststoff-Trennwand 3 ist im Ausführungsbeispiel gemäß Figur 1 zweiteilig gestaltet und weist einen ersten Teil 31 auf, welcher im Wesentlichen vertikal zu den beiden Leiterbahnen 1 und 2 orientiert ist. Der erste Teil 31 erstreckt sich im Ausführungsbeispiel über dem ersten Teil 11 der ersten Leiterbahn 1. Ein zweiter Teil 32 der Kunststoff-Trennwand 2 ist zwischen den Leiterbahnen 1 und 2 angeordnet und im Wesentlichen parallel zu diesen beiden Leiterbahnen 1 und 2 sowie im Wesentlichen parallel zu dem elektrisch leitenden Element 4 ausgebildet.

Ein zweites Ausführungsbeispiel der erfindungsgemäßen Sicherungsvorrichtung ist in Figur 2 gezeigt. Diesbezüglich ist die Kunststoff-Trennwand 3 T-förmig ausgebildet, wobei in diesem Ausführungsbeispiel der erste Teil 31 derart angeordnet ist, dass er sich in vertikaler Orientierung zum elektrisch leitenden Element 4 über dem elektrisch leitenden Element 4 erstreckt.

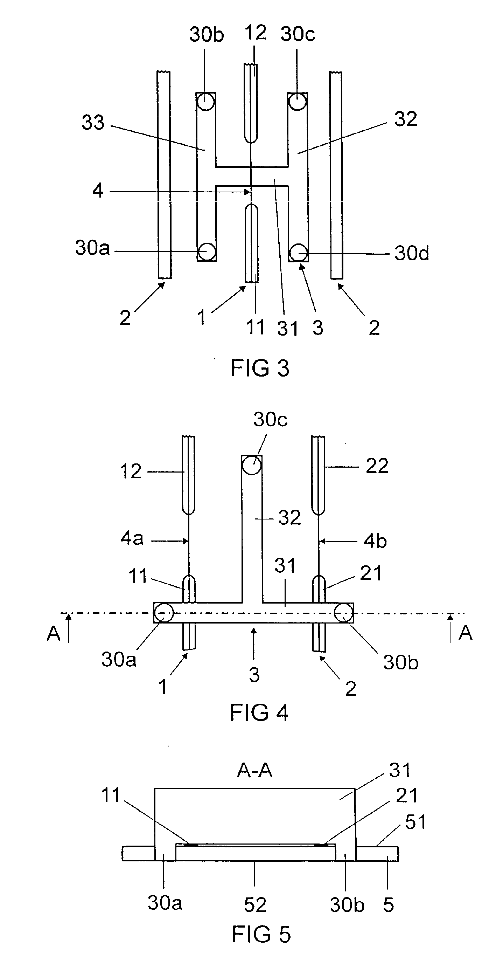

In einem dritten Ausführungsbeispiel gemäß Fig. 3 ist die Kunststoff-Trennwand 3 H-förmig ausgebildet und weist drei Teile 31, 32 und 33 auf. Wie aus der Figur 3 zu erkennen ist, sind zwei Leiterbahnen 2, welche ein gemeinsames Betriebsspannungs-Potential aufweisen, im Wesentlichen parallel zueinander angeordnet, wobei zwischen diesen beiden Leiterbahnen 2 die erste Leiterbahn 1 angeordnet ist. Der erste Teil 31 der Kunststoff-Trennwand 3 ist im gezeigten Ausführungsbeispiel gemäß Figur 3 wiederum vertikal zum elektrisch leitenden Element 4 bzw. zur Leiterbahnsicherung orientiert und erstreckt sich über dem elektrisch leitenden Element 4. Wie aus der Darstellung gemäß Figur 3 zu erkennen ist, ist der horizontal orientierte erste Teil 31 derart über dem elektrisch leitenden Element angeordnet, dass er in etwa mittig platziert ist, und somit im Wesentlichen den gleichen Abstand zu den beiden Teilen 11 und 12 der ersten Leiterbahn 1 aufweist. Darüber hinaus ist der zweite Teil 32 der Kunststoff-Trennwand 3 zwischen der ersten Leiterbahn 1 und der rechts davon ausgebildeten zweiten Leiterbahn 2 derart angeordnet, dass er im Wesentlichen den gleichen Abstand zur Leiterbahn 1 und zur rechten Leiterbahn 2 aufweist. In entsprechender Weise ist der dritte Teil 33 der Kunststoff-Trennwand derart orientiert, dass er im Wesentlichen den gleichen Abstand zur Leiterbahn 1 und der links davon ausgebildeten zweiten Leiterbahn 2 aufweist. Die Anordnung der Leiterbahnen 2 sowie der H-förmigen Kunststoff-Trennwand 3 ist im gezeigten Ausführungsbeispiel gemäß Figur 3 im Wesentlichen symmetrisch zur in der Figurenebene vertikal orientierten Längsachse der Leiterbahn 1 ausgebildet. Die H-förmige Kunststoff-Trennwand 3 ist mittels der vier Einsteckstifte 30a bis 30d fest mit der nicht dargestellten Leiterplatte verbunden.

Ein viertes Ausführungsbeispiel ist in der Figur 4 dargestellt. Diesbezüglich ist sowohl die erste Leiterbahn 1 als auch die zweite Leiterbahn 2 jeweils zweiteilig ausgebildet, wobei zwischen den Teilen 11 und 12 der ersten Leiterbahn 1 ein als Leiterbahnsicherung ausgebildetes elektrisches Element 4a angeordnet ist und zwischen den beiden Teilen 21 und 22 der zweiten Leiterbahn 2 ein als Leiterbahnsicherung ausgebildetes zweites elektrisches Element 4b angeordnet ist. Die Kunststoff-Trennwand 3 ist im Ausführungsbeispiel gemäß Figur 4 T-förmig ausgebildet und erstreckt sich mit ihrem ersten Teil 31 im Wesentlichen senkrecht zur Leiterbahn 1 und zur Leiterbahn 2. Der erste Teil 31 ist dabei derart angeordnet, dass er über dem ersten Teil 11 der ersten Leiterbahn 1 und über dem ersten Teil 21 der zweiten Leiterbahn 2 angeordnet ist. Durch die erfindungsgemäße Ausgestaltung kann erreicht werden, dass die beiden Leiterbahnen 1 und 2 mit den entsprechenden als Leiterbahnsicherungen angeordneten elektrisch leitenden Elementen 4a und 4b relativ nahe nebeneinander angeordnet werden können.

In Figur 5 ist eine Schnittdarstellung des Ausführungsbeispiels gemäß Figur 4 entlang der Schnittlinie AA dargestellt. Wie diesbezüglich zu erkennen ist, sind die Leiterbahnen 1 und 2 bzw. deren erkennbare ersten Teile 11 und 21 an einer Unterseite 51 der Leiterplatte 5 ausgebildet. Wie des Weiteren zu erkennen ist, sind die Einsteckstifte 30a und 30b in entsprechende in der Leiterplatte 5 ausgebildete Lochbereiche eingesteckt. Die Länge der Einsteckstifte 30a und 30b ist dabei derart ausgebildet, dass sie im eingesteckten Endzustand bündig mit der Oberseite 52 der Leiterplatte 5 angeordnet sind. Die Höhe der Kunststoff-Trennwand 3 bzw. des in Figur 5 sichtbaren ersten Teils 31 ist dabei derart gestaltet, dass sie bzw. es unmittelbar mit der den Einsteckstiften 30a und 30b gegenüberliegenden Seite der Kunststoff-Trennwand 3 an einer Bodenplatte des nicht dargestellten Metallgehäuses des elektronischen Vorschaltgerätes anliegend ausgebildet ist.

In der Fertigung kann es auch vorteilhaft sein, die Kunststoff-Trennwand 3 auf die Unterseite 51 der Leiterplatte 5 anzukleben.

## Patentansprüche

1. Sicherungsvorrichtung zum Sichern eines Elektrogeräts vor Überstrom mit
- zumindest einem elektrisch leitenden Element (4, 4a, 4b), welches bei Erreichen des Überstroms schmilzt,
- einer ersten und zumindest einer zweiten Betriebsspannungs-Potentialfläche (1, 2), wobei jede der Betriebsspannungs-Potentialflächen (1,2) mit jeweils einer Betriebsspannungs-Zuleitung elektrisch verbunden ist, und
- zumindest die erste Betriebsspannungs-Potentialfläche (1, 2) zumindest zwei Teile (11, 12; 21, 22) aufweist, wobei die beiden Teile (11, 12; 21, 22) durch das elektrisch leitende Element (4, 4a, 4b) elektrisch verbunden sind, und
- einer Kunststoff-Trennwand (3), welche zwischen der ersten (1) und der zweiten Betriebsspannungs-Potentialfläche (2) angeordnet ist,
**dadurch gekennzeichnet,dass**
die Kunststoff-Trennwand (3) an einer Unterseite eines Bauteilereservoirs (5) des Elektrogeräts angeordnet ist und mit dem Bauteilereservoir (5) mechanisch fest verbunden ist.

2. Sicherungsvorrichtung nach Anspruch 1,
**dadurch gekennzeichnet,dass**
die Kunststoff-Trennwand (3) durch eine Steckverbindung mit dem Bauteilereservoir (5) mechanisch fest verbunden ist.

3. Sicherungsvorrichtung nach Anspruch 2,
**dadurch gekennzeichnet, dass**
die Steckverbindung Einsteckstifte (30a bis 30d) aufweist, welche an der Kunststoff-Trennwand (3) ausgebildet sind und eine Länge aufweisen, die der Dicke des Bauteilereservoirs (5) entspricht.

4. Sicherungsvorrichtung nach einem der vorhergehenden Ansprüche,
**dadurch gekennzeichnet,dass**
sich die Kunststoff-Trennwand (3) teilweise über zumindest eine der beiden Betriebsspannungs-Potentialflächen (1, 2) und/oder über dem elektrisch leitenden Element (4, 4a, 4b) erstreckt.

5. Sicherungsvorrichtung nach Anspruch 4,
**dadurch gekennzeichnet,dass**
die Kunststoff-Trennwand (3) zumindest zweiteilig ausgebildet ist, wobei ein erster Teil (31) im Wesentlichen senkrecht zur Vorzugsrichtung des elektrisch leitenden Elements (4, 4a, 4b) angeordnet ist und ein zweiter Teil (32, 33) im Wesentlichen parallel zur Vorzugsrichtung des elektrisch leitenden Elements (4, 4a, 4b) zwischen den beiden Betriebsspannungs-Potentialflächen (1, 2) angeordnet ist.

6. Sicherungsvorrichtung nach Anspruch 5,
**dadurch gekennzeichnet,dass**
sich der erste Teil (31) über dem elektrisch leitenden Element (4, 4a, 4b) erstreckt, insbesondere mittig über dem elektrisch leitenden Element (4, 4a, 4b) angeordnet ist.

7. Sicherungsvorrichtung nach einem der vorhergehenden Ansprüche,
**dadurch gekennzeichnet, dass**
die Kunststoff-Trennwand (3) L-förmig oder H-förmig oder T-förmig ausgebildet ist.

8. Sicherungsvorrichtung nach einem der vorhergehenden Ansprüche,
**dadurch gekennzeichnet,dass**
zumindest die erste (1) und die zweite Betriebsspannungs-Potentialfläche (2) jeweils zweiteilig ausgebildet ist und die beiden Teile (11, 12; 21, 22) jeweils mit einem elektrisch leitenden Element (4a; 4b) elektrisch verbunden sind.

9. Sicherungsvorrichtung nach einem der vorhergehenden Ansprüche,
**dadurch gekennzeichnet,dass**
das Bauteilereservoir (5) eine Leiterplatte ist und das elektrisch leitende Element (4, 4a, 4b) durch eine Leiterbahn ausgebildet ist.

10. Sicherungsvorrichtung nach einem der vorhergehenden Ansprüche,
**dadurch gekennzeichnet,dass**
das Elektrogerät, insbesondere ein elektronisches Vorschaltgerät für elektrische Lampen, in einem Metallgehäuse angeordnet ist.

11. Sicherungsvorrichtung nach einem der vorhergehenden Ansprüche,
**dadurch gekennzeichnet,dass**
die Kunststoff-Trennwand (3) an der Unterseite (51) des Bauteilereservoirs (5) angeklebt ist.
